# EUROPÄISCHE PATENTSCHRIFT

(11) **EP 3 318 891 B1**
(45) Veröffentlichungstag und Bekanntmachung des Hinweises auf die Patenterteilung: **21.08.2024**
(21) Anmeldenummer: 16197243.5
(22) Anmeldetag: 04.11.2016
(51) Int. Cl.: G01S 7/4863, G01S 7/4865, H01L 27/146, H01L 27/148, G01S 17/894

(54) **EMPFANGSVORRICHTUNG, SENSORVORRICHTUNG SOWIE VERFAHREN ZUR DISTANZBESTIMMUNG**
RECEIVING DEVICE, SENSOR DEVICE AND METHOD FOR DISTANCE MEASUREMENT
DISPOSITIF DE RÉCEPTION, DISPOSITIF DE CAPTEUR ET PROCÉDÉ DE DÉTERMINATION DE DISTANCE

(43) Veröffentlichungstag der Anmeldung: 09.05.2018
(73) Patentinhaber: Espros Photonics AG, 7320 Sargans (CH); Valeo Schalter und Sensoren GmbH, 74321 Bietigheim-Bissingen (DE)
(72) Erfinder: Simon, Jan, 74321 Bietigheim-Bissingen (DE); Lin, Lin, 74321 Bietigheim-Bissingen (DE); Horvath, Peter, 74321 Bietigheim-Bissingen (DE); Schuler, Thomas, 74321 Bietigheim-Bissingen (DE); Müller, Felix, 74321 Bietigheim-Bissingen (DE); Hofmann, Heiko, 74321 Bietigheim-Bissingen (DE); Popp, Martin, 7000 Chur (CH); De Coi, Beat, 7304 Maienfeld (CH)
(74) Vertreter: Otten, Roth, Dobler & Partner mbB Patentanwälte

(56) Entgegenhaltungen:
- EP-A1- 3 211 673
- WO-A1-2010/025331
- WO-A1-2016/128198
- US-A1- 2014 145 281

## Beschreibung

Die Erfindung betrifft eine Empfangsvorrichtung zur Bestimmung einer Distanz zu einem Objekt, eine Sensorvorrichtung sowie ein Verfahren zur Bestimmung einer Distanz zu einem Objekt.

Aus dem Stand der Technik sind zahlreiche Distanzsensoren bekannt, insbesondere TOF-Sensoren ("time of flight"), bei denen bspw. die Distanz über eine Laufzeitmessung eines Lichtsignals bestimmt wird. Aus der WO 2016/128198 oder der US 2014/0145281 A1 ist bspw. jeweils ein TOF-Entfernungssensor bekannt, bei dem die Menge an detektierten Ladungsträgern mit Hilfe einer Modulationsfrequenz in entsprechenden Zeitintervallen aufgeteilt und jeweils gesammelt wird. Zu diesem Zweck werden entsprechende Demodulationspixel verwendet. Über eine Korrelation kann entsprechend die Phaseninformation erhalten werden, aus der sich die Differenzlaufzeit bzw. die Distanz ergibt. Aus der WO 2010/025331 A1 ist eine weitere Demodulationspixel-Architektur mit einer Daisy-chain bekannt.

Aufgabe der Erfindung ist es, eine möglichst präzise Distanzbestimmung zu ermöglichen.

Die Aufgabe wird, ausgehend von einer Empfangsvorrichtung, einer Sensorvorrichtung bzw. einem Verfahren zur Distanzbestimmung der eingangs genannten Art, durch Merkmale der Ansprüche 1, 10 bzw. 11 gelöst.

Durch die in den abhängigen Ansprüchen genannten Maßnahmen sind vorteilhafte Ausführungen und Weiterbildungen der Erfindung möglich.

Die erfindungsgemäße Empfangsvorrichtung dient zur Bestimmung einer Distanz zu einem Objekt. Sie kann bspw. als Bestandteil einer optischen Sensorvorrichtung verwendet werden, wie z.B. im Zusammenhang mit Überwachungsvorrichtungen für Türen oder Tore bei Garagen, Aufzügen, bei Sensoren im Automobilbereich, bei Parkplatzüberwachungen oder dergleichen. Die Empfangsvorrichtung gemäß der Erfindung umfasst daher zunächst einen Empfänger zum Empfangen von reflektierten Signalen, welche an dem Objekt reflektiert werden, zu dem die Distanz bestimmt werden soll. Beim Empfangen der Signale werden photoinduzierte Ladungsträger erzeugt.

Dementsprechend zeichnet sich die erfindungsgemäße Empfangsvorrichtung durch folgende Merkmale bzw. folgenden Aufbau aus: Der Empfänger umfasst eine Halbleiterstruktur zur Detektion von Photonen. Diese Photonen, welche empfangen werden, stammen von den am Objekt reflektierten Signalen. Dabei ist die Halbleiterstruktur wiederum zur rückseitigen Beleuchtung ausgebildet. Eine rückseitige Beleuchtung besitzt in der Regel den Vorteil, dass eine größere Beleuchtungsfläche zur Detektion verwendet werden kann. Trifft die zu detektierende Strahlung z.B. von der Vorderseite auf die Halbleiterstruktur, auf der weitere Halbleiter- bzw. Elektronikkomponenten angebracht sind auf, so steht in der Regel eine geringere Detektionsfläche zur Verfügung. Ein Teil der Fläche zumindest wird bei einer Beleuchtung auf der Vorderseite von diesen weiteren Elektronikkomponenten verdeckt, die bspw. zur Auswertung und Weiterverarbeitung der Signale dienen. Darüber hinaus bietet eine rückseitige Beleuchtung den Vorteil, dass auch ein relativ großer Bereich im Halbleitersubstrat zur Verfügung stehen kann, welcher als photosensitiver Bereich zur Erzeugung photoinduzierter Ladungsträger ausgebildet ist. Dieser photosensitive Bereich ist entsprechend der Rückseite zugewandt.

Neben dem photosensitiven Bereich umfasst die Halbleiterstruktur aber auch einen Transportbereich zum Transport von Ladungsträgern. Über diesen Bereich können zunächst die erzeugten Ladungsträger aus dem photosensitiven Bereich ab- bzw. weitertransportiert werden. Insbesondere kann durch den Transportbereich auch ermöglicht werden, eine zeitliche Abfolge in eine räumliche Abfolge umzuwandeln, was insbesondere dazu verwendet werden kann, eine präzise Zeitmessung durchzuführen und somit auch die Distanzbestimmung zu verbessern. Der photosensitive Bereich und der Transportbereich sind durch eine Trennschicht voneinander getrennt, jedoch mit Ausnahme eines Durchlasses zwischen dem photosensitiven Bereich und dem Transportbereich, welcher es ermöglicht, dass Ladungsträger aus dem photosensitiven Bereich in den Transportbereich gelangen können.

Die Trennschicht kann bei einer Ausführungsform der Erfindung als vergrabene Schicht ausgebildet sein. Eine vergrabene Schicht kann im Bulk-Material, zum Beispiel durch Ionenimplantation, erzeugt werden. Die abschirmende bzw. abtrennende Wirkung der Trennschicht kann durch die Dotierung erreicht werden. Grundsätzlich kann sie aber auch als Nichtleiter-Schicht ausgebildet sein. Die Trennschicht kann ferner auf dem Bulk aufgetragen werden, wobei der über der Trennschicht befindliche Bereich dadurch gebildet wird, dass weitere Schichten aufwachsen, sodass eine Art SandwichBauweise entsteht.

Der Durchlass ermöglicht insbesondere, dass die Ladungsträger an einer definierten Stelle in die Umgebung des Transportbereichs gelangen können. In zeitlichen Intervallen können somit separate Ladungsträgermengen über den Transportbereich vom Bereich des Durchlasses aus weitertransportiert werden. Hierdurch entsteht somit eine feste Zuordnung eines Ortes zu einer Ladungsträgermenge, die zu einer bestimmten Zeit bzw. in einem bestimmten Zeitintervall im Halbleitersubstrat erzeugt wurde. Zum Transport der Ladungsträger weist der Transportbereich eine Anordnung von wenigstens zwei nebeneinanderliegenden Gattern auf, von denen sich wenigstens eines der Gatter im Überdeckungsbereich des Durchlasses befindet. Diese Gatter im Überdeckungsbereich des Durchlasses können somit durch den Durchlass hindurch direkt auf Ladungsträger im photosensitiven Bereich einwirken, z.B. diese anziehen.

Die Ladungsträger, welche im photosensitiven Bereich der Halbleiterstruktur erzeugt wurden, können durch das Potential eines Gatters beeinflusst werden. Dementsprechend ist bei einer Ausführungsform der Erfindung an jedes der Gatter eine Spannung anlegbar, um Ladungsträger im Transportbereich unter das jeweilige Gatter zu bewegen. Gatter, welche im Überdeckungsbereich des Durchlasses angeordnet sind, können somit die Ladungsträger aus dem photosensitiven Bereich herausbewegen und in ihre Umgebung, also in den Transportbereich transportieren.

Weitere, neben den im Überdeckungsbereich des Durchlasses befindlichen Gattern angeordnete Gatter können für den Weitertransport der Ladungsträgermengen sorgen. Durch dieses "Absaugen" der Ladungsträger aus dem photosensitiven Bereich in den Transportbereich und dem Weitertransport innerhalb des Transportbereichs werden die Ladungsträger je nachdem, wann bzw. in welchem Zeitintervall sie erzeugt wurden, aus dem photosensitiven Bereich entfernt und weitertransportiert. Aus diesem zeitlichen Ablauf ergibt sich mit Hilfe der Empfangsvorrichtung somit eine räumliche Abfolge bzw. eine räumliche Darstellung des Signals. Die Zuordnung der vorgegebenen zeitlichen Abfolge zu entsprechenden Raumkoordinaten ergibt sich aus der Geometrie des Transportbereichs bzw. der räumlichen Anordnung der Gatter innerhalb des Transportbereichs. Sind die Gatter nebeneinanderliegend angeordnet, so wird die zeitliche Koordinate jeweils einer räumlichen Koordinate entlang der Streckenanordnung der Gatter zugeordnet.

Um diese zeitlich-räumliche Zuordnung zu vereinfachen und regelmäßig bzw. fortdauernd ablaufen zu lassen, ist erfindungsgemäß ein Taktgeber vorgesehen, um abwechselnd an die Gatter nacheinander eine Spannung anzulegen. Die Ladungsträger werden somit unter das jeweilige Gatter bewegt bzw. entlang des Transportbereichs transportiert. Hierdurch wird eine fortlaufende Detektion ermöglicht, und es werden jedem Punkt auf der Transportstrecke durch die Taktvorgabe eindeutige zeitliche Koordinaten zugeordnet. Durch die Auswahl der Taktung kann insbesondere auch die zeitliche Auflösung bestimmt werden. In der Regel ist darauf zu achten, dass die Taktfrequenz an den Ladungsträgertransport von Gatter zu Gatter angepasst wird, damit beim Transport möglichst wenig Ladungsträger verloren gehen.

Bei einer Ausführungsform der Erfindung weisen der photosensitiver Bereich und der Durchlass eine erste Dotierung auf, während die Trennschicht eine zweite Dotierung und der Transportbereich eine dritte Dotierung aufweist. Die zweite Dotierung, die also der Trennschicht zuzuordnen ist, ist ungleichnamig zur ersten bzw. dritten Dotierung, sodass die Ladungsträger hierdurch abgeschirmt werden können.

Wie bereits dargestellt, ist bei einer Ausführungsform der Erfindung das wenigstens eine im Überdeckungsbereich des Durchlasses angeordnete Gatter dazu ausgebildet, die Ladungsträger durch den Durchlass hindurch aus dem photosensitiven Bereich in den Transportbereich zu bewegen, indem an das Gatter eine entsprechende Spannung angelegt werden kann. Denkbar ist auch, dass der Durchlassbereich von zwei oder mehr Gattern überdeckt wird. Das Abtransportieren der Ladungsträger aus dem photosensitiven Bereich ist notwendig, um den photosensitiven Bereich wiederum freizugeben für weitere, zeitlich später erzeugte Ladungsträger. Ferner sollen beim Weitertransport der bereits aus dem photosensitiven Bereich bewegten Ladungsträger diese entsprechenden Ladungsträgermengen auf der Transportstrecke weitertransportiert werden können, sodass ihnen eine räumliche Koordinate entsprechend ihres Zeitpunktes oder Zeitraumes der Detektion zugeordnet wird.

Der Taktgeber dient somit erfindungsgemäß dazu, eine zeitliche Auflösung in eine räumliche Auflösung umzuwandeln, wobei er dazu ausgebildet ist, die Ladungsträger aus dem photosensitiven Bereich in zeitlich vorgegebenen Intervallen in den Transportbereich zu bewegen und von dort entlang des Transportbereichs weiter zu transportieren. Durch die Taktrate ist auch einstellbar, wie präzise das empfangene Signal in seinem zeitlichen Verlauf abgetastet werden soll.

Erfindungsgemäß ist der Transportbereich als Conveyor Belt-Struktur eines CCD ausgebildet (CCD: "charge-coupled device"). Bei einer Conveyor Belt-Struktur sind nebeneinander mehrere Elektroden bzw. Gatter angeordnet, die abwechselnd mit einem Pontential beaufschlagt werden, sodass die in den Bereichen befindlichen Ladungsträger angezogen oder abgestoßen werden. Somit können von Gate zu Gate Ladungsträgermengen bzw. -pakete bewegt werden. Auch bei einem CCD werden entsprechend die Gatter abwechselnd mit einem Potential beaufschlagt, das bspw. die entsprechenden Ladungsträger, die sich in der Umgebung befinden, anziehen kann. Zum Transport befindet sich z.B. eine bestimmte Menge an Ladungsträgern unter einem Gatter, das mit einem Potential beaufschlagt ist. Im weiteren Verlauf wird das daneben liegende Gatter mit dem gleichen Potential beaufschlagt. Ein Teil der Ladungsträger bewegt sich somit unter das zweite, benachbarte Gatter. Dann wird das Potential des ersten Gatters geändert, sodass die gesamte Menge an Ladungsträgern von dem zweiten Gatter angezogen wird und sich hierunter ansammelt. Auf diese Weise kann der Transport der Ladungsträger realisiert werden.

Bei einem Ausführungsbeispiel der Erfindung können die Gatter als Metallkontakte ausgebildet sein, die auf der Vorderseite des Halbleitersubstrats, also auf der dem Transportbereich zugewandten Seite, angeordnet sind. Die Metallkontakte ermöglichen es, dass die Ladungsträger einem vergleichsweise hohen Potential ausgesetzt werden können. Hierdurch kann der der Transport verbessert und der Verlust an Ladungsträgern beim Transport verringert werden.

Um die Erzeugung photoinduzierter Ladungsträger zu begünstigen, sind der photosensitive Bereich und der Durchlass (erste Dotierung) bei einem Ausführungsbeispiel vergleichsweise schwach dotiert. Damit die Trennschicht (zweite Dotierung) eine gute Trennung bzw. Isolierung darstellt, ist diese vorteilhafterweise wesentlich höher dotiert.

Um einen raschen Transport der Ladungsträger zu ermöglichen, kann die dritte Dotierung im Transportbereich ebenfalls vergleichsweise stark ausgebildet sein.

Um schließlich das detektierte Signal in seiner zeitlichen Folge auslesen zu können, umfasst der Transportbereich erfindungsgemäß eine Auslesevorrichtung zur Bestimmung der Menge der Ladungsträger. Dieses Auslesen geschieht in der Reihenfolge, in der die Ladungsträgermengen über die Transportstrecke bzw. über die Gatter zur Auslesevorrichtung gelangen. Bei der Bestimmung der Mengen der Ladungsträger ist es i.d.R. lediglich notwendig, im zeitlichen bzw. räumlichen Verlauf relative Unterschiede der bestimmten Mengen feststellen zu können. Eine Bestimmung einzelner absoluter Werte ist dagegen i.d.R. nicht notwendig. Auf diese Art und Weise, bei der lediglich relative Größenvergleiche der Mengen an Ladungsträger untersucht werden, ist es zumindest möglich, den Verlauf des Signals insoweit zu bestimmen, dass ein Extremum des Signals sehr präzise erkannt werden kann. Dies gilt umso mehr, wenn der prinzipielle Verlauf des detektierten Signals bekannt ist. Handelt es sich bspw. um einen Gauß-Puls, so wird erwartet, dass dieser eine regelmäßige und vorbekannte Form mit einem Extremum, nämlich einem Maximum aufweist. Durch eine gewichtete Mittelwertbildung bzw. durch eine Bestimmung der Steigungen bzw. Flanken des Signals kann somit die Form im zeitlichen Ablauf des Signals rekonstruiert werden, wobei insbesondere die Position des Maximums (in der zeitlichen Abfolge) sehr genau bestimmt werden kann. Hierdurch wird also auch eine präzise Distanzmessung ermöglicht, da dementsprechend auch präzise festgestellt werden kann, welche Laufzeit das Signal gebraucht hat.

Bei einer Ausführungsvariante der Erfindung kann somit z.B. eine Zeitmessvorrichtung zur Bestimmung der Zeitspanne zwischen dem Aussenden des Lichtspulses und dem Empfangen des reflektierten Lichtpulses vorgesehen sein. Je nach Art der Sensorvorrichtung kann explizit mit einer Laufzeit, mit einer Phasenverschiebung oder dergleichen gearbeitet werden. Erfindungsgemäß ist eine Auswerteeinrichtung vorgesehen, welche dazu ausgebildet ist, das Maximum im zeitlichen Intensitätsverlauf des Lichtsignals bzw. des Lichtpulses zu bestimmen. Hierzu kann ein Mittelwert (arithmetisch, geometrisch) bestimmt werden.

Das Signal, das auf die Empfangsvorrichtung bzw. den Empfänger trifft und im Halbleitersubstrat bzw. in dessen photosensitiven Bereich detektiert wird, weist einen zeitlichen Verlauf auf. In den entsprechenden Zeitintervallen werden somit Teile des Signals in Form von Ladungsträgermengen aus dem photosensitiven Bereich abtransportiert und über eine Transportstrecke eines Transportbereichs bewegt. Im nächsten Zeitintervall der Detektion wird ein neuer Teil des empfangenen Lichtsignals in Ladungsträger umgewandelt, und diese werden ebenfalls auf die Transportstrecke des Transportbereichs bewegt, jedoch zeitlich versetzt zu der zuvor transportierten Ladungsmenge und deshalb mit einer anderen räumlichen Koordinate zu gleichen Zeitpunkten. Da im zeitlichen Verlauf diese entsprechenden abgetasteten Signalteile jeweils die vorgegebenen Raumpunkte auf der Transportstrecke nacheinander durchlaufen, besteht eine eindeutige Zuordnung zwischen dem Zeitpunkt der Detektion bzw. des Auftretens des Signals und der räumlichen Koordinate innerhalb der Transportstrecke auf den Transportbereich. Insbesondere dann, wenn das Signal eine bereits vorgegebene Form hat, vorteilhafterweise eine einfache Form mit einem einzigen Extremum, bspw. einem Gauß-Puls, kann durch Mittelwertbildung bzw. durch Detektion der Flanke über die Steigungen eine Bestimmung des räumlichen Schwerpunktes der Ladungsverteilung erfolgen. Die Mittelwertbildung bzw. die Flankendetektion ermöglichen es, den Schwerpunkt des detektierten Signals genauer zu bestimmen als die durch die Gatterstruktur vorgegebene Auflösung bzw. in zeitlicher Hinsicht genauer als die vorgegebene Taktung. Hierdurch kann also in vorteilhafter Weise die gesuchte Distanz sehr präzise gemessen werden.

Darüber hinaus ermöglicht die Erfindung, dass auch ein in seinem zeitlichen Verlauf schnell variierendes Signal "entzerrt" wird und somit besser verarbeitet werden kann, weil das Signal lediglich mit einer vergleichsweise niedrigen Auflösung abgetastet wird, die Information über den räumlichen bzw. zeitlichen Schwerpunkt jedoch erhalten bleibt.

Bei einer Weiterbildung der Erfindung kann der Empfänger insbesondere als Matrix ausgebildet sein, d.h. die Distanzmessung ist nicht die einzige räumliche Information, die gewonnen werden kann, sondern durch die Matrix kann auch eine zweidimensionale Struktur entsprechend abgetastet werden. Insbesondere können somit 3D-Sensoren in vorteilhafter Weise hergestellt werden. Gerade in der Tiefenauflösung besitzen derartige 3D-Sensoren eine besonders hohe Leistungsfähigkeit.

Demensprechend zeichnet sich eine erfindungsgemäße Sensorvorrichtung zur Bestimmung einer Distanz zu einem Objekt dadurch aus, dass ein Sender zum Aussenden von Lichtpulsen sowie eine erfindungsgemäße Empfangsvorrichtung bzw. eine Empfangsvorrichtung gemäß einem der Ausführungsbeispiele der Erfindung verwendet wird. Die Sensorvorrichtung kann insbesondere als TOF-Sensorvorrichtung ausgebildet sein. Somit können die bereits zuvor genannten Vorteile der Erfindung bzw. der entsprechenden Ausführungsbeispiele der Erfindung für eine derartige Sensorvorrichtung genutzt werden.

Ferner zeichnet sich ein erfindungsgemäßes Verfahren zur Bestimmung einer Distanz zu einem Objekt, bei dem die Lichtlaufzeit eines Pulses gemessen wird durch folgende Verfahrensschritte aus. Zunächst wird ein Lichtpuls ausgesendet, insbesondere mit einem Maximum im zeitlichen Intensitätsverlauf. Der Lichtpuls wird an einem Objekt reflektiert und das reflektierte Signal empfangen, wobei hierzu ein photosensitiver Bereich eines Halbleitersubstrats einer Halbleiterstruktur zur Erzeugung photoinduzierter Ladungsträger verwendet wird. In der Halbleiterstruktur wird ein Transportbereich bereitgestellt, der durch eine Trennschicht vom photosensitiven Bereich abgetrennt ist, jedoch einen Durchlass aufweist, sodass ein Transport der Ladungsträger durch den Durchlass, nicht jedoch durch die Trennschicht erfolgen kann.

Der Durchlass kann bei einem Ausführungsbeispiel im Vergleich zum photosensitiven Bereich bzw. zum Transportbereich eine gleichnamige Dotierung aufweisen.

Im Bereich der Transportstrecke im Transportbereich werden mindestens zwei nebeneinanderliegende Gatter bereitgestellt, wobei die im Überdeckungsbereich des Durchlasses angeordneten Gatter dafür sorgen können, dass Ladungsträger aus dem photosensitven Bereich in den Transportbereich gelangen. Das Weiterleiten der Ladungsträger über die Transportstrecke erfolgt zeitgetaktet. Insgesamt können zur Durchführung dieses Verfahrens Empfangsvorrichtungen bzw. Sensorvorrichtungen gemäß der Erfindung bzw. einem Ausführungsbeispiel der Erfindung verwendet werden. Die zeitliche Abfolge des detektierten Signals wird somit in eine räumliche Abfolge umgewandelt. Durch Weiterleitung über die Transportstrecke kann die Abfolge des gerasterten Pulses gemessen werden. Durch Mittelwertbildung oder Flankendetektion kann wiederum der räumliche Schwerpunkt der Ladungsverteilung und somit der zeitliche Schwerpunkt des Signals bestimmt werden. Diese Bestimmung kann präziser sein als die durch die Taktung vorgegebene zeitliche Rasterung. Die Zeit, die zur Auswertung des Signals zur Verfügung steht, kann länger sein als die zeitliche Variation des Signals selbst. Daher kann auch die Detektion vergleichsweise kostengünstig erfolgen.

### Ausführungsbeispiel:

Ein Ausführungsbeispiel der Erfindung ist in den Zeichnungen dargestellt und wird nachstehend unter Angabe weiterer Einzelheiten und Vorteile näher erläutert. Im Einzelnen zeigen:
- Figur 1:: eine schematische Darstellung einer Empfangsvorrichtung gemäß der Erfindung, sowie
- Figur 2:: eine schematische Darstellung einer Sensorvorrichtung gemäß der Erfindung.

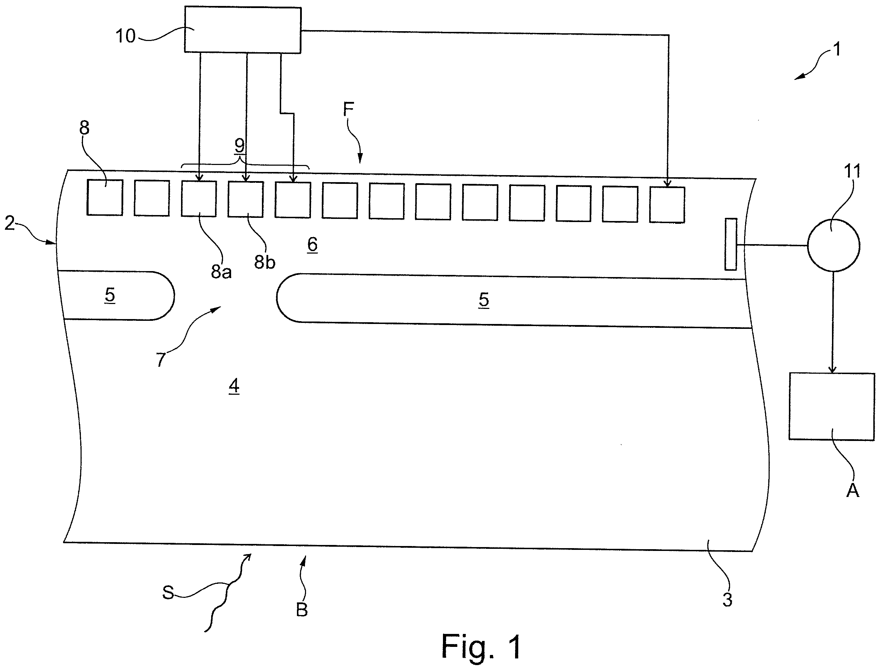

Figur 1 zeigt eine schematische Darstellung einer Empfangsvorrichtung 1 gemäß der Erfindung. Die Empfangsvorrichtung bzw. der Empfänger umfasst eine Halbleiterstruktur 2 mit einem Halbleitersubstrat 3. Die Halbleiterstruktur 2 wiederum besitzt eine Vorderseite F und eine Rückseite B, wobei die zu detektierenden Lichtsignale S auf die Rückseite B treffen. Im Bereich der Rückseite B ist ein photosensitiver Bereich 4 vorhanden. Dringen die zu detektierenden Photonen in diesen photosensitiven Bereich ein, so erfolgt eine Elektron-Loch-Paaraufspaltung, d.h. es entstehen photoinduzierte Ladungsträger.

Der photosensitive Bereich 4 ist zunächst durch die Trennschicht 5, die eine ungleichnamige Dotierung zum photosensitiven Bereich 4 aufweist, abgetrennt von einem weiteren Bereich, dem Transportbereich 6. Die Trennschicht 5 ist jedoch nicht durchgängig ausgebildet, sondern besitzt einen Durchlass 7, der eine gleichnamige Dotierung wie der photosensitive Bereich 4 und der Transportbereich 6 aufweist. Über diesen Durchlass 7 können die Ladungsträger aus dem photosensitiven Bereich in den Transportbereich 6 gelangen. Der Transportbereich 6 besitzt eine wesentlich stärkere Dotierung als der photosensitive Bereich 4.

Im oberen Bereich des Transportbereiches 6, welcher der Vorderseite F zugewandt ist, sind entlang einer Transportstrecke des Transportbereichs 6 einzelne Gatter 8 angeordnet. Der Überdeckungsbereich 9 des Durchlasses 7 befindet sich dort, wo die Gatter 8a und 8b angeordnet sind. Durch Anlegen eines Potentials bzw. einer Spannung an diese Gatter 8a, 8b können Ladungsträger aus dem photosensitiven Bereich 4 durch den Durchlass 7 hindurch in den Transportbereich 6 gelangen. Mithilfe eines Taktgebers 10 werden nacheinander Spannungen an die Gatter 8 angelegt, angefangen von den Gattern 8a, 8b bis hin zum rechten Rand der Transportstrecke in Figur 1.

Sind Elektronen infolge einer an ein Gatter angelegten Spannung unter dieses Gatter bewegt worden, so wird im nächsten Takt das danebenliegende Gatter ebenfalls mit einer gleichnamigen Spannung beaufschlagt, sodass Ladungsträger auch zu diesem herüberwandern können. Das ursprüngliche Gatter ändert in der Folge sein Potential, sodass die Ladungsträgermenge vollständig unter das benachbarte Gatter wandern kann usw. Am Ende der Transportstrecke 6 steht eine Auslesevorrichtung 11 zum Auslesen der Ladungsträgermengen. Im Anschluss daran können außerhalb des in Figur 1 dargestellten Pixels bzw. des Teils der Empfangsvorrichtung 1 weitere Komponenten vorgesehen sein, bspw. ein A/D-Wandler, um das analoge Signal, welches die bestimmte Ladungsträgermenge angibt, in ein digitales Signal umzuwandeln. Anschließend kann noch weitere Auswerteelektronik vorgesehen sein, etwa um eine Mittelwertbildung oder Flankendetektion zu realisieren und um so den räumlichen Schwerpunkt der Ladungsverteilung über die Strecke des Transportbereichs 6 zu ermitteln. Hierzu können die Signale an eine Auswerteeinrichtung A weitergegeben werden. Es ist denkbar, die Signale vor der Verarbeitung in der Auswerteeinrichtung A mittels eines A/D-Wandlers von analog zu digital zu wandeln.

Durch die Taktung, die durch den Taktgeber 10 vorgegeben ist, wird auch eine entsprechende Integrationszeit vorgegeben, mit der das detektierte Lichtsignal abgetastet wird. In diesen einzelnen durch die Taktung vorgegebenen Zeitintervallen können die Ladungsträger unter einem der Gates 8 integriert werden.

Die Erfindung besitzt insbesondere den Vorteil, dass die Einflüsse von Umgebungslicht auf den Vorgang zur Bestimmung der gesuchten Distanz möglichst gering gehalten werden können und auch vermieden wird, dass fälschlicherweise nicht durch das Ausgangssignal bedingte Extrema gemessen werden. Insbesondere sind die durch das Umgebungslicht zu erwartenden Schwankungen des Lichts sehr niederfrequent in Bezug auf die ausgesendeten Lichtpulse. Die mittlere Laufzeit des ausgesendeten Pulses wird somit auch durch Schwankungen des Umgebungslichts nicht beeinflusst. Die Mittelwertbildung oder auch die Flankendetektion mitteln diese Schwankungen heraus.

Darüber hinaus ist es in vorteilhafter Weise nicht von Bedeutung, ob ein genauer Wert der absoluten Ladungsmenge bestimmt werden kann. Hierdurch können auch in vorteilhafter Weise die Kosten für die eigentliche Photodetektor-Struktur reduziert werden. Insofern ist es auch möglich, lichtschwächere Signale zu verwenden und die Intensität einer solchen Sensorvorrichtung herabsetzen zu können.

Auch dann, wenn (versehentlich) in gewissen Grenzen eine Überbelichtung stattfindet, können sich die erzeugten Ladungsträger über benachbarte Gatter verteilen, soweit diese "geöffnet" sind, also ein Potential aufweisen, das die Anziehung der Ladungsträger in diesen Bereich ermöglicht. Auch in diesem Fall kann über eine Mittelung verhindert werden, dass die Güte des Signals beeinflusst bzw. wesentlich beeinflusst wird.

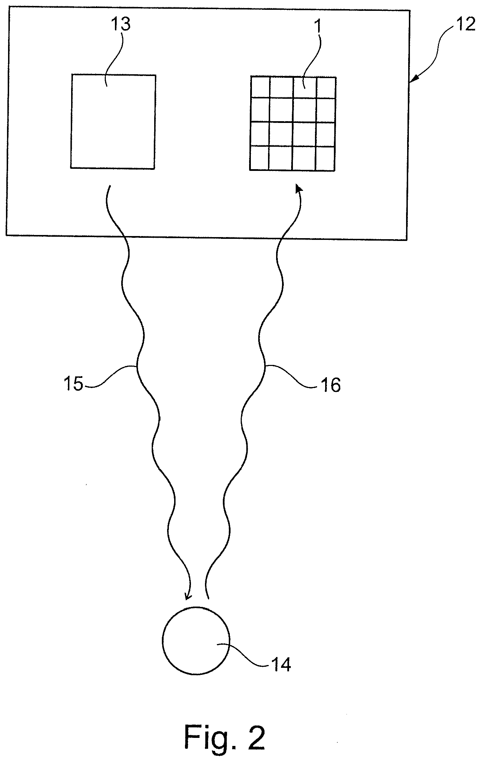

Figur 2 zeigt eine schematische Darstellung einer Sensorvorrichtung 12 gemäß der Erfindung mit einem Sender 13 und einem Empfänger 1, wobei der Sender 13 ein Lichtsignal 15 aussendet, das an einem Objekt 14 reflektiert wird, wobei das reflektierte Signal 16 von der Empfangsvorrichtung 1 erfasst wird. Die Empfangsvorrichtung 1 ist als Matrix ausgebildet.

### Bezugszeichenliste:

- 1: Empfangsvorrichtung
- 2: Halbleiterstruktur
- 3: Halbleitersubstrat
- 4: photosensitiver Bereich
- 5: Trennschicht
- 6: Transportbereich
- 7: Durchlass
- 8: Gatter
- 8a: Gatter im Überdeckungsbereich des Durchlasses
- 8b: Gatter im Überdeckungsbereich des Durchlasses
- 9: Überdeckungsbereich
- 10: Taktgeber
- 11: Auslesevorrichtung
- 12: Sensorvorrichtung
- 13: Sender
- 14: Objekt
- 15: ausgesandtes Signal
- 16: reflektiertes Signal

- A: Auswerteeinrichtung
- B: Rückseite
- F: Vorderseite
- S: Detektierte Lichtsignale

## Patentansprüche

1. Empfangsvorrichtung (1) zur Bestimmung einer Distanz zu einem Objekt (14), umfassend:
- einen Empfänger zum Empfangen von vom Objekt (14) reflektierten Signalen (16) und zur Erzeugung von photoinduzierten Ladungsträgern,
wobei
- der Empfänger eine Halbleiterstruktur (2) zur Detektion von Photonen umfasst,
- wobei die Halbleiterstruktur (2) zur rückseitigen Beleuchtung ausgebildet ist,
- wobei die Halbleiterstruktur (2) ein Halbleitersubstrat (3) mit einem photosensitiven Bereich (4) zur Erzeugung photoinduzierter Ladungsträger, welcher der Rückseite (B) zugewandt ist, und einen Transportbereich (6) zum Transport der Ladungsträger, welcher der Vorderseite (F) zugewandt ist, aufweist,
- wobei der photosensitive Bereich (4) und der Transportbereich (6) durch eine Trennschicht (5), welche einen Durchlass (7) zwischen dem photosensitiven Bereich (4) und dem Transportbereich (6) aufweist, voneinander räumlich getrennt sind, wobei die Trennschicht (5) insbesondere als vergrabene Schicht ausgebildet ist,
- wobei der Transportbereich (6) eine Anordnung von wenigstens zwei nebeneinander liegenden Gattern (8, 8a, 8b) aufweist, von denen sich wenigstens eines der Gatter (8a, 8b) im Überdeckungsbereich (9) des Durchlasses (7) befindet,
wobei an jedes der Gatter (8, 8a, 8b) eine Spannung anlegbar ist, um Ladungsträger im Transportbereich (6) unter das jeweilige Gatter (8, 8a, 8b) zu bewegen,
wobei ein Taktgeber (10) vorgesehen ist, um abwechselnd an die Gatter (8, 8a, 8b) nacheinander eine Spannung anzulegen, um die Ladungsträger unter das jeweilige Gatter (8, 8a, 8b) zu bewegen und diese somit entlang des Transportbereichs (6) zu transportieren,
wobei der Taktgeber (10) dazu ausgebildet ist, die Ladungsträger aus dem photosensitiven Bereich (4) in zeitlich vorgegebenen Intervallen in den Transportbereich (6) zu bewegen und von dort entlang des Transportbereichs (6) weiter zu transportieren, um eine zeitliche Auflösung in eine räumliche Auflösung umzuwandeln,
wobei der Transportbereich (6) als Conveyor-Belt-Struktur eines CCD ausgebildet ist, sodass die nebeneinander angeordneten Gatter mit der Spannung beaufschlagt werden, sodass die in den Bereichen befindlichen Ladungsträger angezogen oder abgestoßen werden, um die Ladungsträger von Gatter zu Gatter zu bewegen,
wobei der Transportbereich (6) am Ende der Transportstrecke (6) eine Auslesevorrichtung (11) umfasst zur Bestimmung von Landungsträgermengen in der Reihenfolge, in der die Ladungsträgermengen über die Gatter zur Auslesevorrichtung gelangen, und eine Auswerteeinrichtung (A) vorgesehen ist, welche dazu ausgebildet ist, aus dem (sich daraus ergebenden) zeitlichen Verlauf der bestimmten Ladungsträgermengen ein Maximum im zeitlichen Intensitätsverlauf des reflektierten Signals zu bestimmen.

2. Empfangsvorrichtung (1) nach Anspruch 1, **dadurch gekennzeichnet, dass** das wenigstens eine im Überdeckungsbereich (9) des Durchlasses (7) angeordnete Gatter (8a, 8b) dazu ausgebildet ist, die Ladungsträger durch den Durchlass (7) aus dem photosensitiven Bereich (4) in den Transportbereich (6) zu bewegen, indem an das entsprechende und/oder die entsprechenden Gatter (8a, 8b) eine Spannung anlegbar ist.

3. Empfangsvorrichtung (1) nach einem der vorgenannten Ansprüche, **dadurch gekennzeichnet, dass** der photosensitive Bereich (4) und der Durchlass (7) eine erste Dotierung aufweisen,
- wobei die Trennschicht (5) eine zweite Dotierung aufweist und der Transportbereich (6) eine dritte Dotierung aufweist,
- wobei die zweite Dotierung ungleichnamig zur ersten und/oder dritten Dotierung ist.

4. Empfangsvorrichtung (1) nach Anspruch 3, **dadurch gekennzeichnet, dass** die erste Dotierung im Vergleich zur zweiten und/oder dritten Dotierung schwach ausgebildet ist.

5. Empfangsvorrichtung (1) nach Anspruch 3 oder 4, **dadurch gekennzeichnet, dass** die dritte Dotierung stärker ausgebildet ist als die erste Dotierung.

6. Empfangsvorrichtung (1) nach einem der vorgenannten Ansprüche, **dadurch gekennzeichnet, dass** der Empfänger als Matrix ausgebildet ist.

7. Empfangsvorrichtung (1) nach einem der vorgenannten Ansprüche, **dadurch gekennzeichnet, dass** die Auswerteeinrichtung (A) dazu ausgebildet ist, das Maximum im zeitlichen Intensitätsverlauf eines Lichtpulses zu bestimmen.

8. Empfangsvorrichtung (1) nach einem der vorgenannten Ansprüche, **dadurch gekennzeichnet, dass** zur Bestimmung des Maximums die Auswerteeinrichtung (A) dazu ausgebildet ist, einen Mittelwert zu bilden oder eine Erkennung des Wechsels von steigender zu fallender Pulsflanke vorzunehmen.

9. Empfangsvorrichtung (1) nach einem der vorgenannten Ansprüche, **dadurch gekennzeichnet, dass** eine Zeitmessvorrichtung zur Bestimmung der Zeitspanne zwischen Aussenden des Lichtpulses und Empfangen des reflektieren Lichtpulses vorgesehen ist.

10. Sensorvorrichtung (12) zur Bestimmung einer Distanz zu einem Objekt, **dadurch gekennzeichnet, dass** ein Sender (13) zum Aussenden von Lichtpulsen, sowie eine Empfangsvorrichtung (1) nach einem der vorgenannten Ansprüche vorgesehen sind, um deren am Objekt (14) reflektierte Signale zu detektieren, wobei die Sensorvorrichtung (12) insbesondere als TOF-Sensorvorrichtung ausgebildet ist.

11. Verfahren zur Bestimmung einer Distanz zu einem Objekt, bei dem die Lichtlaufzeit eines Pulses gemessen wird, wobei folgende Verfahrensschritte durchgeführt werden:
- Aussenden eines Lichtpulses (15), insbesondere mit einem Maximum im zeitlichen Intensitätsverlauf;
- Empfangen des an dem Objekt reflektierten Signals (16) in einem photosensitiven Bereich (4) eines Halbleitersubstrats (3) einer Halbleiterstruktur (2) zur Erzeugung photoinduzierter Ladungsträger,
- Bereitstellen eines durch eine Trennschicht (5) abgetrennten Transportbereichs (6) mit einer Transportstrecke zum Transport der Ladungsträger und mit einem Durchlass (7) zwischen dem photosensitiven Bereich (4) und dem Transportbereich (6), sodass ein Transport der Ladungsträger durch den Durchlass (7), nicht aber durch die Trennschicht (5) erfolgen kann, wobei als Trennschicht (5) insbesondere eine vergrabene Schicht verwendet wird,
- Bereitstellen von wenigstens zwei nebeneinander liegenden Gattern (8, 8a, 8b) im Bereich der Transportstrecke, von denen sich wenigstens eines der Gatter (8a, 8b) im Überdeckungsbereich (9) des Durchlasses (7) befindet, sodass durch Anlegen einer Spannung die Ladungsträger über den Durchlass (7) angezogen werden können,
- Transport der Ladungsträger in getrennten Zeitintervallen durch den Durchlass (7) in den Transportbereich (6), um den zeitlichen Verlauf der Intensität des Lichtpulses räumlich über die Transportstrecke abzubilden,
- zeitgetaktetes Weiterleiten der Ladungsträger über die Transportstrecke,
- wobei insbesondere eine Empfangsvorrichtung (1) und/oder eine Sensorvorrichtung (12) nach einem der vorgenannten Ansprüche verwendet wird,
- wobei vorzugsweise der Schwerpunkt der räumlichen Abbildung des Intensitätsverlaufs des Lichtpulses per Mittelwertbildung und/oder Flankendetektion bestimmt wird, wobei an jedes der Gatter (8, 8a, 8b) eine Spannung angelegt wird, um Ladungsträger im Transportbereich (6) unter das jeweilige Gatter (8, 8a, 8b) zu bewegen,
wobei abwechselnd an die Gatter (8, 8a, 8b) nacheinander durch einen Taktgeber (10) eine Spannung angelegt wird, um die Ladungsträger unter das jeweilige Gatter (8, 8a, 8b) zu bewegen und diese somit entlang des Transportbereichs (6) zu transportieren,
wobei die Ladungsträger durch den Taktgeber (10) aus dem photosensitiven Bereich (4) in zeitlich vorgegebenen Intervallen in den Transportbereich (6) bewegt und von dort entlang des Transportbereichs (6) weiter transportiert werden, um eine zeitliche Auflösung in eine räumliche Auflösung umzuwandeln,
wobei durch den als Conveyor-Belt-Struktur eines CCD ausgebildeten Transportbereich (6) die nebeneinander angeordneten Gatter mit der Spannung beaufschlagt werden, sodass die in den Bereichen befindlichen Ladungsträger angezogen oder abgestoßen werden, um die Ladungsträger von Gatter zu Gatter zu bewegen,
wobei im Transportbereich (6) am Ende der Transportstrecke (6) mittels einer Auslesevorrichtung (11) die Landungsträgermengen in der Reihenfolge, in der die Ladungsträgermengen über die Gatter zur Auslesevorrichtung gelangen, bestimmt werden und mit einer Auswerteeinrichtung (A) aus dem (sich daraus ergebenden) zeitlichen Verlauf der bestimmten Ladungsträgermengen ein Maximum im zeitlichen Intensitätsverlauf des reflektierten Signals bestimmt wird.

## Claims

1. Receiving apparatus (1) for determining a distance from an object (14), comprising:
- a receiver for receiving signals (16) reflected by the object (14) and for generating photo-induced charge carriers,
wherein
- the receiver comprises a semiconductor structure (2) for detecting photons,
- wherein the semiconductor structure (2) is designed for back-side illumination,
- wherein the semiconductor structure (2) has a semiconductor substrate (3) with a photosensitive region (4) for generating photo-induced charge carriers, the photosensitive region facing the back side (B), and a transport region (6) for transporting the charge carriers, the transport region facing the front side (F),
- wherein the photosensitive region (4) and the transport region (6) are spatially separated from one another by a separation layer (5) which has a gap (7) between the photosensitive region (4) and the transport region (6), wherein the separation layer (5) is designed in particular as a buried layer,
- wherein the transport region (6) has an arrangement of at least two adjacent gates (8, 8a, 8b), of which at least one of the gates (8a, 8b) is located in the cover region (9) of the gap (7),
wherein a voltage may be applied to each of the gates (8, 8a, 8b) in order to move charge carriers in the transport region (6) to below the respective gate (8, 8a, 8b),
wherein a clock (10) is provided to successively apply a voltage to the gates (8, 8a, 8b) in alternation in order to move the charge carriers to below the respective gate (8, 8a, 8b) and to transport them in this way along the transport region (6),
wherein the clock (10) is designed to move the charge carriers out of the photosensitive region (4) in temporally specified intervals into the transport region (6) and to transport them further from there along the transport region (6) in order to convert a temporal resolution into a spatial resolution,
wherein the transport region (6) is designed as a conveyor belt structure of a CCD, with the result that the voltage is applied to the adjacent gates so that the charge carriers located in the regions are attracted or repulsed in order to move the charge carriers from gate to gate,
wherein the transport region (6) comprises at the end of the transport path (6) a readout apparatus (11) for determining quantities of charge carriers in the order in which the quantities of charge carriers reach the readout apparatus via the gates, and an evaluation device (A) is provided, which is designed to determine from the (resulting) temporal profile of the determined quantities of charge carriers a maximum in the temporal intensity profile of the reflected signal.

2. Receiving apparatus (1) according to Claim 1, **characterized in that** the at least one gate (8a, 8b) arranged in the cover region (9) of the gap (7) is designed to move the charge carriers through the gap (7) out of the photosensitive region (4) into the transport region (6) by a voltage being able to be applied to the corresponding gate and/or the corresponding gates (8a, 8b) .

3. Receiving apparatus (1) according to either of the preceding claims, **characterized in that** the photosensitive region (4) and the gap (7) have a first doping,
- wherein the separation layer (5) has a second doping and the transport region (6) has a third doping,
- wherein the second doping is unlike the first and/or third doping with respect to the sign of the charges.

4. Receiving apparatus (1) according to Claim 3, **characterized in that** the first doping is weak in comparison with the second and/or third doping.

5. Receiving apparatus (1) according to Claim 3 or 4, **characterized in that** the third doping is stronger than the first doping.

6. Receiving apparatus (1) according to any of the preceding claims, **characterized in that** the receiver is designed as a matrix.

7. Receiving apparatus (1) according to any of the preceding claims, **characterized in that** the evaluation device (A) is designed to determine the maximum in the temporal intensity profile of a light pulse.

8. Receiving apparatus (1) according to any of the preceding claims, **characterized in that** the evaluation device (A) is designed, for the purpose of determining the maximum, to form an average or to perform a detection of the change from a rising to a falling pulse edge.

9. Receiving apparatus (1) according to any of the preceding claims, **characterized in that** a time measurement apparatus for determining the time period between transmitting the light pulse and receiving the reflected light pulse is provided.

10. Sensor apparatus (12) for determining a distance from an object, **characterized in that** a transmitter (13) for transmitting light pulses and a receiving apparatus (1) according to any of the preceding claims are provided in order to detect the signals thereof reflected at the object (14), wherein the sensor apparatus (12) is designed in particular as a TOF sensor apparatus.

11. Method for determining a distance from an object, wherein the time of flight of a pulse is measured, wherein the following method steps are carried out:
- transmitting a light pulse (15), in particular with a maximum in the temporal intensity profile;
- receiving the signal (16) reflected at the object in a photosensitive region (4) of a semiconductor substrate (3) of a semiconductor structure (2) to generate photo-induced charge carriers,
- providing a transport region (6), separated by a separation layer (5), with a transport path for transporting the charge carriers and with a gap (7) between the photosensitive region (4) and the transport region (6) such that transport of the charge carriers can be effected through the gap (7) but not through the separation layer (5), wherein in particular a buried layer is used as the separation layer (5),
- providing at least two adjacent gates (8, 8a, 8b) in the region of the transport path, of which at least one of the gates (8a, 8b) is located in the cover region (9) of the gap (7), with the result that, by applying a voltage, the charge carriers can be attracted via the gap (7),
- transporting the charge carriers in separate time intervals through the gap (7) into the transport region (6) in order to map the remaining profile of the intensity of the light pulse spatially over the transport path,
- guiding the charge carriers further over the transport path in a clocked manner,
- wherein in particular a receiving apparatus (1) and/or a sensor apparatus (12) according to any of the preceding claims is used,
- wherein preferably the centroid of the spatial mapping of the intensity profile of the light pulse per average formation and/or edge detection is determined,
wherein a voltage is applied to each of the gates (8, 8a, 8b) in order to move charge carriers in the transport region (6) to below the respective gate (8, 8a, 8b),
wherein a voltage is applied successively to the gates (8, 8a, 8b) in alternation by a clock (10) in order to move the charge carriers to below the respective gate (8, 8a, 8b) and to transport them in this way along the transport region (6), wherein the charge carriers are moved by the clock (10) out of the photosensitive region (4) in temporally specified intervals into the transport region (6) and are transported further from there along the transport region (6) in order to convert a temporal resolution into a spatial resolution,
wherein the voltage is applied to the adjacent gates through the transport region (6), which is designed as a conveyor belt structure of a CCD, with the result that the charge carriers located in the regions are attracted or repulsed, in order to move the charge carriers from gate to gate,
wherein, in the transport region (6) at the end of the transport path (6), the quantities of charge carriers are determined, by means of a readout apparatus (11), in the order in which the quantities of charge carriers reach the readout apparatus via the gates, and a maximum in the temporal intensity profile of the reflected signal is determined by means of an evaluation device (A) from the (resulting) temporal profile of the determined quantities of charge carriers.

## Revendications

1. Dispositif de réception (1) destiné à déterminer une distance par rapport à un objet (14), comprenant :
- un récepteur destiné à recevoir des signaux (16) réfléchis par l'objet (14) et à générer des porteurs de charge photoinduits,
- le récepteur comprenant une structure semi-conductrice (2) destinée à la détection de photons,
- la structure semi-conductrice (2) étant conçue pour l'éclairage par l'arrière,
- la structure semi-conductrice (2) présentant un substrat semi-conducteur (3) pourvu d'une zone photosensible (4) destinée à générer des porteurs de charge photoinduits, laquelle est tournée vers la face arrière (B), et d'une zone de transport (6) destinée au transport des porteurs de charge, laquelle est tournée vers la face avant (F),
- la zone photosensible (4) et la zone de transport (6) étant séparées spatialement l'une de l'autre par une couche de séparation (5) qui présente un passage (7) entre la zone photosensible (4) et la zone de transport (6), la couche de séparation (5) étant notamment réalisée sous la forme d'une couche enterrée,
- la zone de transport (6) présentant un agencement d'au moins deux portes (8, 8a, 8b) situées côte à côte, parmi lesquelles au moins l'une des portes (8a, 8b) se trouve dans la zone de recouvrement (9) du passage (7),
une tension pouvant être appliquée à chacune des portes (8, 8a, 8b) pour déplacer des porteurs de charge vers la zone de transport (6) sous la porte respective (8, 8a, 80) ,
une horloge (10) étant prévue pour appliquer alternativement une tension aux portes (8, 8a, 8b) l'une après l'autre afin de déplacer les porteurs de charge sous la porte respective (8, 8a, 8b) et de les transporter ainsi le long de la zone de transport (6),
l'horloge (10) étant conçue pour déplacer les porteurs de charge de la zone photosensible (4) vers la zone de transport (6) à des intervalles de temps prédéfinis et pour les transporter plus loin depuis cet emplacement le long de la zone de transport (6), afin de convertir une résolution temporelle en une résolution spatiale,
la zone de transport (6) étant réalisée sous la forme d'une structure de bande transporteuse d'un CCD, de sorte que les portes disposées côte à côte sont soumises à la tension, afin que les porteurs de charge se trouvant dans les zones soient attirés ou repoussés pour déplacer les porteurs de charge d'une porte à l'autre,
la zone de transport (6) comprenant, à l'extrémité du trajet de transport (6), un dispositif de lecture (11) destiné à déterminer des quantités de porteurs de charge dans l'ordre dans lequel les quantités de porteurs de charge parviennent au dispositif de lecture par l'intermédiaire des portes, et un dispositif d'évaluation (A) étant prévu, lequel est conçu pour déterminer, à partir de la courbe temporelle (qui en résulte) des quantités de porteurs de charge déterminées, un maximum dans la courbe d'intensité temporelle du signal réfléchi.

2. Dispositif de réception (1) selon la revendication 1, **caractérisé en ce que** l'au moins une porte (8a, 8b) disposée dans la zone de recouvrement (9) du passage (7) est conçue pour déplacer les porteurs de charge à travers le passage (7) de la zone photosensible (4) vers la zone de transport (6), en faisant en sorte qu'une tension puisse être appliquée à la porte correspondante et/ou aux portes correspondantes (8a, 8b).

3. Dispositif de réception (1) selon l'une des revendications précédentes, **caractérisé en ce que** la zone photosensible (4) et le passage (7) présentent un premier dopage,
- la couche de séparation (5) présentant un deuxième dopage et la zone de transport (6) présentant un troisième dopage,
- le deuxième dopage étant de signe différent du premier et/ou du troisième dopage.

4. Dispositif de réception (1) selon la revendication 3, **caractérisé en ce que** le premier dopage est conçu pour être faible par rapport au deuxième et/ou au troisième dopage.

5. Dispositif de réception (1) selon la revendication 3 ou 4, **caractérisé en ce que** le troisième dopage est conçu pour être plus élevé que le premier dopage.

6. Dispositif de réception (1) selon l'une des revendications précédentes, **caractérisé en ce que** le récepteur est réalisé sous forme de matrice.

7. Dispositif de réception (1) selon l'une des revendications précédentes, **caractérisé en ce que** le dispositif d'évaluation (A) est conçu pour déterminer le maximum dans la courbe d'intensité temporelle d'une impulsion lumineuse.

8. Dispositif de réception (1) selon l'une des revendications précédentes, **caractérisé en ce que**, pour la détermination du maximum, le dispositif d'évaluation (A) est conçu pour calculer une valeur moyenne ou pour procéder à une détection du passage d'un front d'impulsion montant à un front d'impulsion descendant.

9. Dispositif de réception (1) selon l'une des revendications précédentes, **caractérisé en ce qu'**il est prévu un dispositif de mesure du temps destiné à déterminer l'intervalle de temps entre l'émission de l'impulsion lumineuse et la réception de l'impulsion lumineuse réfléchie.

10. Dispositif de capteur (12) destiné à déterminer une distance par rapport à un objet, **caractérisé en ce qu'**il est prévu un émetteur (13) destiné à émettre des impulsions lumineuses, ainsi qu'un dispositif de réception (1) selon l'une des revendications précédentes, destiné à détecter leurs signaux réfléchis sur l'objet (14), le dispositif de capteur (12) étant notamment réalisé sous la forme d'un dispositif de capteur TOF.

11. Procédé de détermination d'une distance par rapport à un objet, dans lequel le temps de propagation de la lumière d'une impulsion est mesuré, les étapes de procédé suivantes étant effectuées :
- émission d'une impulsion lumineuse (15), présentant notamment un maximum dans la courbe d'intensité temporelle ;
- réception du signal (16) réfléchi sur l'objet dans une zone photosensible (4) d'un substrat semi-conducteur (3) d'une structure semi-conductrice (2) destinée à générer des porteurs de charge photoinduits,
- fourniture d'une zone de transport (6) séparée par une couche de séparation (5) présentant un trajet de transport destiné au transport des porteurs de charge et présentant un passage (7) entre la zone photosensible (4) et la zone de transport (6), de sorte qu'un transport des porteurs de charge peut s'effectuer à travers le passage (7), mais pas à travers la couche de séparation (5), une couche enterrée étant notamment utilisée en tant que couche de séparation (5),
- fourniture d'au moins deux portes (8, 8a, 8b) disposées côte à côte dans la zone du trajet de transport, parmi lesquelles au moins l'une des portes (8a, 8b) se trouve dans la zone de recouvrement (9) du passage (7), de sorte que, par application d'une tension, les porteurs de charge peuvent être attirés par l'intermédiaire du passage (7),
- transport des porteurs de charge à des intervalles de temps séparés à travers le passage (7) vers la zone de transport (6), afin de reproduire spatialement la courbe d'intensité temporelle de l'impulsion lumineuse sur le trajet de transport,
- acheminement cadencé par horloge des porteurs de charge sur le trajet de transport,
- un dispositif de réception (1) et/ou un dispositif de capteur (12) selon l'une des revendications précédentes étant notamment utilisés,
- le centre de gravité de la représentation spatiale de la courbe d'intensité de l'impulsion lumineuse étant de préférence déterminé par calcul de la valeur moyenne et/ou par détection de fronts,
une tension étant appliquée à chacune des portes (8, 8a, 8b) pour déplacer des porteurs de charge dans la zone de transport (6) sous la porte respective (8, 8a, 8b),
une tension étant appliquée alternativement aux portes (8, 8a, 8b) l'une après l'autre par une horloge (10) afin de déplacer les porteurs de charge sous la porte respective (8, 8a, 8b) et de les transporter ainsi le long de la zone de transport (6),
les porteurs de charge étant déplacés par l'horloge (10) à des intervalles de temps prédéfinis depuis la zone photosensible (4) vers la zone de transport (6) et étant transportés plus loin depuis cet emplacement le long de la zone de transport (6), afin de convertir une résolution temporelle en une résolution spatiale,
les portes disposées côte à côte étant soumises à la tension à travers la zone de transport (6) réalisée sous la forme d'une structure de bande transporteuse d'un CCD, afin que les porteurs de charge se trouvant dans les zones soient attirés ou repoussés pour déplacer les porteurs de charge d'une porte à l'autre,
dans la zone de transport (6), à l'extrémité du trajet de transport (6), les quantités de porteurs de charge étant déterminées au moyen d'un dispositif de lecture (11) dans l'ordre dans lequel les quantités de porteurs de charge parviennent au dispositif de lecture par l'intermédiaire des portes, et un maximum dans la courbe d'intensité temporelle du signal réfléchi étant déterminé au moyen d'un dispositif d'évaluation (A) à partir de la courbe temporelle (qui en résulte) des quantités de porteurs de charge déterminées.
